# EUROPÄISCHE PATENTSCHRIFT

(11) **EP 0 541 879 B1**
(45) Veröffentlichungstag und Bekanntmachung des Hinweises auf die Patenterteilung: **12.07.1995**
(21) Anmeldenummer: 91810881.2
(22) Anmeldetag: 14.11.1991
(51) Int. Cl.: F26B 15/22

(54) **Durchlauftrockner für flächenförmiges Stückmaterial**
Continuous dryer for plane-shaped articles
Sécheur en continu pour articles de forme plane

(43) Veröffentlichungstag der Anmeldung: 19.05.1993
(73) Patentinhaber: CIBA-GEIGY AG, 4002 Basel (CH)
(72) Erfinder: Kuster, Kaspar, CH-4057 Basel (CH)

(56) Entgegenhaltungen:
- BE-A- 672 267
- DE-A- 1 604 944
- DE-C- 448 186
- GB-A- 574 761
- US-A- 1 692 294
- US-A- 4 390 093

## Beschreibung

Die Erfindung betrifft einen Durchlauftrockner für flächenförmiges Stückmaterial, insbesondere für flüssigbeschichtete Leiterplatten und dergleichen, gemäss dem Oberbegriff von Patentanspruch 1.

Ein derartiger Trockner ist zum Beispiel aus der DE-A-1 604 944 bekannt.

Beschrieben ist weiterhin ein Durchlauftrockner in der DE-A-32 39 868. Bei dem dort beschriebenen Trockner läuft das zu trocknende Stückmaterial, das beispielsweise durch eine auf ihrer Oberseite flüssigbeschichtete Leiterplatte gebildet sein kann, horizontal in eine Einlaufstation des Trockners ein. Dies kann beispielsweise auf einer Rollenbahn erfolgen, die eine horizontale Einlaufbahn beschreibt. In dieser Einlaufstation wird die Unterseite der Leiterplatte von einem Träger erfasst, der mit einem umlaufenden Kettenförderer verbunden ist, und wird mit Hilfe des Trägers von dieser Rollenbahn nach oben abgehoben. Der Kettenförderer, an dessen Kette viele solcher Träger befestigt sind, beschreibt eine geschlossene umlaufende Bahn, von der ein Teil als Transportbahn für die einzelnen Leiterplatten genutzt wird. Zunächst wird die mit Hilfe eines solchen Trägers von der Einlaufrollenbahn abgehobene Leiterplatte aufwärts transportiert bis hin zu einer oberen Umlenkstelle, an der die Kette umgelenkt wird und wieder abwärts geführt ist. Entsprechend wird nach dem Umlenken des Trägers auch die Leiterplatte wieder mit abwärts geführt. Unterschreitet der abwärts geführte Träger, der die Leiterplatte trägt, ein bestimmtes Niveau, auf welchem eine Auslaufstation mit einer horizontal verlaufenden Auslaufrollenbahn für die Platten angeordnet ist, bleibt die Leiterplatte auf dieser Auslaufrollenbahn liegen, während sich der Träger weiter abwärts bewegt. Die auf der Auslaufrollenbahn liegende Platte wird aus der Auslaufstation abtransportiert, bevor der nächste von oben kommende abwärts geführte Träger das Niveau der Auslaufrollenbahn erreicht. Der nun unbeladene Träger wird weiter abwärts geführt, an einer unteren Umlenkstelle umgelenkt, wieder aufwärtsgeführt, hebt in der Einlaufstation wieder eine Leiterplatte von der Einlaufrollenbahn ab und der gleiche Zyklus beginnt von neuem.

Nachdem die Platte zu Beginn ihres Transports mittels des Trägers von der Einlaufrollenbahn abgehoben worden ist, gelangt sie im Laufe ihres Aufwärtstransports aus dem unteren Gehäuseteil, in dem sowohl die Einlaufstation als auch die Auslaufstation vorgesehen sind, in den oberen Gehäuseteil des Trockners. Dieser obere Gehäuseteil ist mit einer Bodentrennwand versehen, die diesen oberen Gehäuseteil von dem unteren Gehäuseteil abtrennt, abgesehen von den Duchtritten, die für den bereits beschriebenen Transportmechanismus (Kettenförderer mit Trägern, die die Leiterplatten tragen) und die aufliegenden Platten vorgesehen sein müssen. Diese Abtrennung der Gehäuseteile dient in erster Linie der thermischen Abtrennung. Während sich die jeweilige Leiterplatte auf ihrem Transportweg in diesem oberen Gehäuseteil befindet, wird nämlich zur Trocknung der Platte gemäss der DE-A-32 39 868 beheizte Luft derart über die Platte geführt, dass der Luftstrom in der Richtung bzw. entgegen der Richtung über die Platte geführt ist, in der die Träger bei ihrer Aufwärts- bzw. bei ihrer Abwärtsbewegung von der Kette des Kettenförderers abstehen. Dazu wird die Luft im wesentlichen von der Seite, auf der die Auslaufstation angeordnet ist, dem oberen Gehäuseteil zugeführt und auf der Seite, auf der die Einlaufstation angeordnet ist, wieder abgesaugt Gelangt die Platte nach dem Durchlaufen des oberen Gehäuseteils in die Auslaufstation, wird sie durch die dort herrschende erheblich niedrigere Temperatur wieder abgekühlt.

Dieser Trockner und andere ähnliche zum Stand der Technik gehörende Trockner sind zwar prinzipiell funktionsfähig, weisen aber noch verbesserungswürdige Nachteile auf. Zuerst einmal ist es bei solchen Trocknern üblich, dass die zu trocknenden Platten schon abgelüftet sind, also dass ein wesentlicher Teil der in der Beschichtungsmasse, z.B. einem Lötstopplack, enthaltenen Lösungsmittel vor dem eigentlichen Trocknungsvorgang schon abgeführt worden ist, damit die Trocknung der beschichteten Platte im Trockner ausreichend ist. Dies bedingt üblicherweise eine vor den Trockner vorgeschaltete Ablüftstation, die einerseits zusätzlichen technischen Aufwand und erhebliche zuätzliche Kosten bedeutet und zudem auch noch separaten Platz beansprucht. Ein weiterer Nachteil bekannter Trockner ist die Art und Weise wie die Träger, die sogenannten "Racks", die die Platten durch den Trockner transportieren, ausgebildet und an der Transportkette befestigt sind. In der EP-A-0 070 805 ist nämlich bereits auf das Problem hingewiesen, dass die einzelnen Kettenglieder bzw. die Verbindungsstifte der einzelnen Kettenglieder der Transportkette sehr ungleichmässig belastet sind, wenn die einzelnen Racks nicht jeweils genau in der Mitte des zugehörigen Kettenglieds befestigt und zusätzlich auch noch etwa gleichmässig beladen sind. Zudem sind bei den bisher bekannten Trocknern die Racks zumeist so ausgebildet, dass zwei aufeinanderfolgende Racks einen grösseren Abstand voneinander haben müssen, damit die Zinken von aufeinanderfolgender Racks bzw. die Racks selbst sich nicht behindern können. Dadurch kann die Kapazität des Trockners bzw. die "Packungsdichte", mit der die Platten aufeinander folgend durch den Trockner transportiert werden können, erheblich eingeschränkt sein. Nachteilig ist auch die Art und Weise der Luftstromführung, wie sie in der DE-A-32 39 868 beschrieben ist, die zu einer ungleichmässigen und oft nur ungenügenden Trocknung der beschichteten Platten führen kann. Dort wird nämlich der Luftstrom in der Richtung bzw. entgegengesetzt zu der Richtung, in der die Racks von der Kette abstehen, über die zu trocknenden Platten geführt. In der DE-A-32 39 868 ist dies so gelöst, dass die Luft auf der Seite der absteigenden Transportstrecke zugeführt wird, also zunächst über die abwärts transportierten Platten hinweg und dann weiter über die auf der Seite der aufsteigenden Transportstrecke aufwärts geführten Platten hinweg geführt ist, bevor er dann auf der Seite der aufsteigenden Transportstrecke wieder abgesaugt wird. Mit anderen Worten, die Trockenluft wird längs eines relativ langen Wegs über mehrere Platten hinweg geführt, bevor sie wieder abgesaugt wird. Längs eines solchen relativ langen Luftwegs kann es zu erheblichen Ungleichmässigkeiten und Schwankungen des Trockenluftstroms, beispielsweise zu Verwirbelungen etc. kommen, so dass ungleichmässige oder auch ungenügende Trocknung der Platten die Folge sein kann.

Ein weiterer Durchlauftrockner zum Trocknen von Platten ist aus der BE-A-672,267 bekannt. Der dort beschriebene Trockner umfasst eine endlose umlaufende Kette, an welcher Träger befestigt sind. Die Träger sind aus Holmen oder Zinken gebildet, die von der Kette nach aussen abstehen. Der Luftstrom zur Trocknung der Platten verläuft quer zu der Richtung, in welche die Träger von der Kette abstehen, über die Platten.

Auch aus der bereits erwähnten DE-A-1,604,944 ist ein ähnlicher Durchlauftrockner für Platten bekannt. In diesem Trockner sind an einer umlaufenden Kette Zinken befestigt und zwar derart, dass an jedem Kettenglied mehrere Zinken befestigt sind. Die Zinken stehen von der Kette nach aussen ab und tragen die Platten. Zum Trocknen der Platten verläuft auch hier der Luftstrom quer zu der Richtung, in welche die Träger von der Kette abstehen, über die Platten.

Ausgehend von diesem Stand der Technik ist es die Aufgabe der vorliegenden Erfindung einen Durchlauftrockner vorzuschlagen, der einen kurzen Luftweg und damit einen gleichmässigen Luftstrom über die zu trocknenden Platten hinweg ermöglicht. Weiterhin soll der Trockner eine hohe Packungsdichte an zu trocknenden Platten ermöglichen, ohne dass sich aufeinanderfolgende Racks dabei behindern. Zudem soll der Ablüft- und Trockenvorgang in ein und demselben Gerät möglich sein, um Platz zu sparen.

Diese Aufgabe wird erfindungsgemäss durch durch die Merkmale des Patentanspruchs 1 gelöst. Durch diese Ausgestaltung kann der Luftweg kurz gehalten werden und der Luftstrom gleichmässig über die jeweilige Platte hinweg geführt werden, so dass eine gute Trocknung der Platte gewährleistet ist. Auch ergibt diese Anordnung eine besonders hohe Packungsdichte an zu trocknenden Platten und somit eine optimale Raumnutzung.

In einer Weiterbildung des erfindungsgemässen Trockners ist an jedem Glied der Transportkette ein Träger befestigt. Die beiden Seitenholme eines Trägers weisen dabei jeweils etwa ein U-Profil auf, dessen Schenkel jeweils auf den anderen Holm zuweisen. Die Tragelemente sind derart mit den Seitenholmen verbunden, dass das eine Ende eines Tragelements an der Aussenwand des einen U-Schenkels und das andere Ende an der Innenwand des anderen U-Schenkels des jeweiligen Seitenholms befestigt sind. Dabei überschreitet die Breite der Seitenholme zuzüglich der Dicke der Tragelemente die Länge eines Kettenglieds der Transportkette nicht. Diese Weiterbildung ist ebenfalls im Hinblick auf eine hohe Packungsdichte an zu beschichtenden Platten vorteilhaft, da sie ermöglicht, zwei aufeinanderfolgende Träger möglichst dicht aufeinander folgen zu lassen, wobei die aufeinanderfolgenden Träger jeweils durch das an der Aussenwand des U-Schenkels befestigte Ende der Tragelemente auf Abstand voneinander gehalten werden. Ausserdem kann auch die flüssigbeschichtete Fläche einer Platte auf diese Weise wegen des Abstands aufeinanderfolgender Träger nicht durch einen folgenden Träger beschädigt werden. Schliesslich muss auch zwischen zwei Trägern noch ein Spalt vorhanden sein, um den Luftstrom über die zu trocknende Platte führen zu können. Um möglichst jedes Kettenglied mit einem Träger belegen zu können, darf die Breite eines Seitenholms zuzüglich der Dicke der Tragelemente die Länge eines Kettenglieds nicht überschreiten. In einer Ausführungsvariante des erfindungsgemässen Trockners umfasst die Transportstrecke zwei Triplex-Ketten, die durch jeweils drei miteinander verbundene parallel zueinander umlaufende Gliederbänder gebildet sind. Das jeweilige äussere Gliederband in einer Führung umläuft und dient zur Führung der gesamten Triplex-Kette. An den beiden anderen Gliederbändern sind die Träger abwechselnd an der einen Triplex-Kette am mittleren Gliederband und gleichzeitig an der anderen Triplex-Kette am inneren Gliederband befestigt, so dass jedes Kettenglied belegt ist Gleichzeitig wird durch diese Art der Kettenbelegung bewirkt, dass sich Zug- und Druckkräfte bzw. die auf die Verbindungsstifte der einzelnen Kettenglieder wirkenden Momente kompensieren können, wodurch das gesamte "Rackpaket" stabil wird und die Kette erheblich geringer belastet wird, als wenn die Kräfte bzw. die Momente additiv auf die Kette wirken würden.

In einer vorteilhaften Ausgestaltung sind in der Nähe des Fussendes der Seitenholme Stützstege für das Stückmaterial vorgesehen, die sich jeweils zwischen zwei hintereinander folgenden Seitenholmen zweier Träger zu den zugehörigen gegenüberliegenden Seitenholmen hin erstrecken. Diese Stützstege dienen dazu, dass sich das Stückmaterial in Form der Platte insbesondere während des Umlenkens gegen sie abstützen kann.

Um die Platte zunächst vorzuheizen und sie nach der heissesten Trockenzone langsam wieder an die Umgebeungstemperatur heranzuführen, sind in dem Trocknergehäuse mehrere Zonen vorgesehen, die auf unterschiedliche Temperaturen beheizt und voneinander thermisch getrennt sind. In jeder Temperaturzone ist dabei eine separate Zuführung für Trockenluft vorgesehen. Die Temperaturzone umfassen dabei also eine Vorwärmzone im ersten Abschnitt der Transportstrecke, in der die Temperatur beispielsweise im Bereich von etwa 30-70° C liegt, eine nachfolgende Heissluftzone, in der die Temperatur beispielsweise im Bereich von etwa 80-110° C liegt sowie eine abschliessende Abkühlzone, in der die Temparatur beispielsweise im Bereich von etwa 15-30° C liegt.

Die Temperaturzonen sind durch Trennwände voneinander getrennt, die sich von dem seitlichen Gehäuseaufbau weg bis zu den Seitenholmen hin erstrecken. Sie sind mit lippenartigen Dichtungen versehen, an denen die Seitenholme der Träger vorbeigeführt sind, so dass die Seitenholme im Zusammenwirken mit den lippenartigen Dichtungen die thermische Abtrennung der einzelnen Temperaturzonen voneinander bewirken.

Im folgenden wird die Erfindung anhand der Zeichnung näher erläutert Es zeigen in teilweise schematischer Darstellung:
- Fig. 1: ein Ausführungsbeispiel des erfindungsgemässen Durchlauftrockners in einem Längsschnitt,
- Fig. 2: einen Träger für die zu trocknenden Platten im Zusammmenbau,
- Fig. 3: eine Ansicht des Trägers gemäss der Linie III-III der Fig. 2,
- Fig. 4: eine Ansicht des Trägers gemäss der Linie IV-IV der Fig. 2,
- Fig. 5: eine Ansicht dreier aufeinanderfolgender Träger beim Aufwärtstransport der Platten,
- Fig. 5a: eine Ansicht der drei Träger gemäss dem Pfeil Va der Fig. 5,
- Fig. 6: das Detail VI der Fig. 5 vergrössert,
- Fig. 7: eine Ansicht dreier aufeinanderfolgender Träger beim Abwärtstransport der Platten,
- Fig. 8: das Detail VIII der Fig. 7 vergrössert,
- Fig. 9: einen Ansicht gemäss der Linie IX-IX der Fig. 1
- Fig. 10: eine Prinzipdarstellung der Kräfte, die auf die Kette wirken,
- Fig. 11: eine Ansicht gemäss der Linie XI-XI der Fig. 1,
und
- Fig. 12: das Detail XII-XII der Fig. 11 vergrössert.

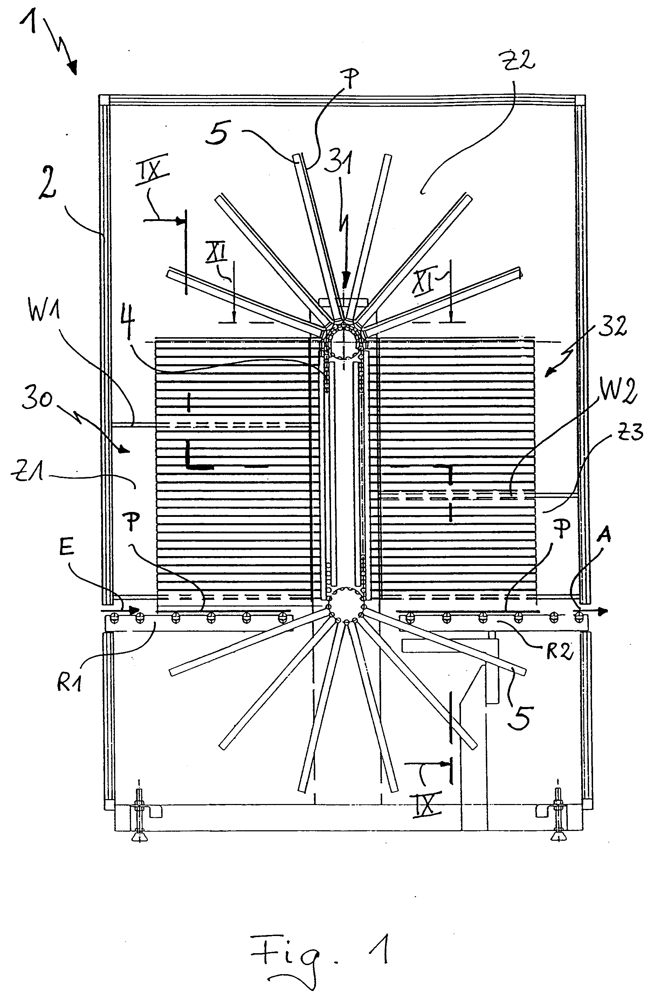

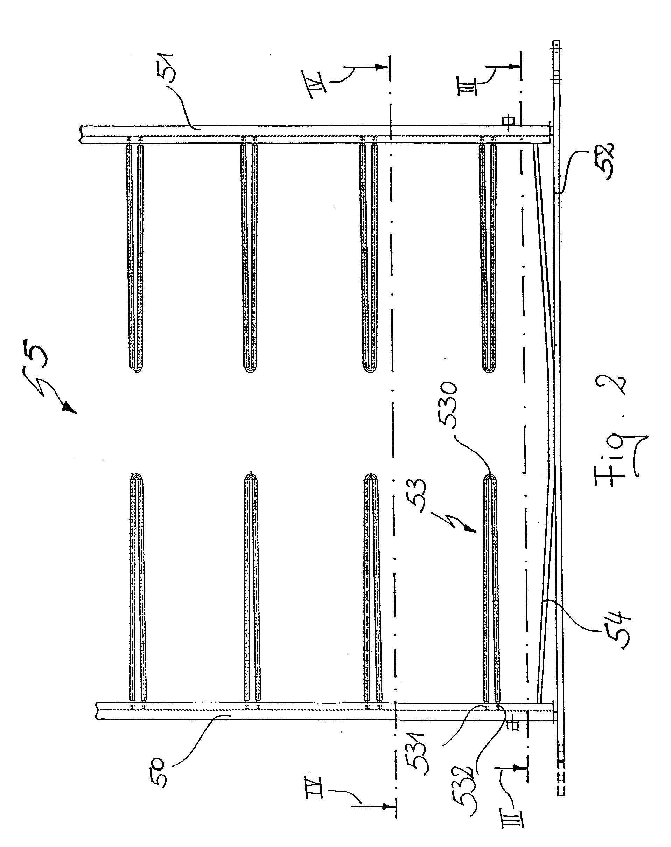

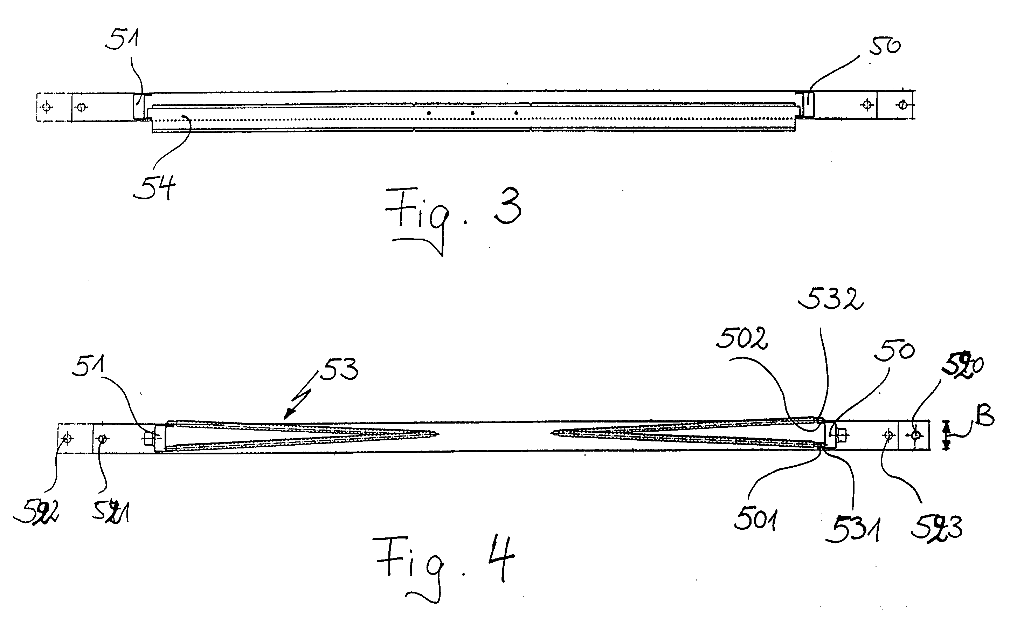

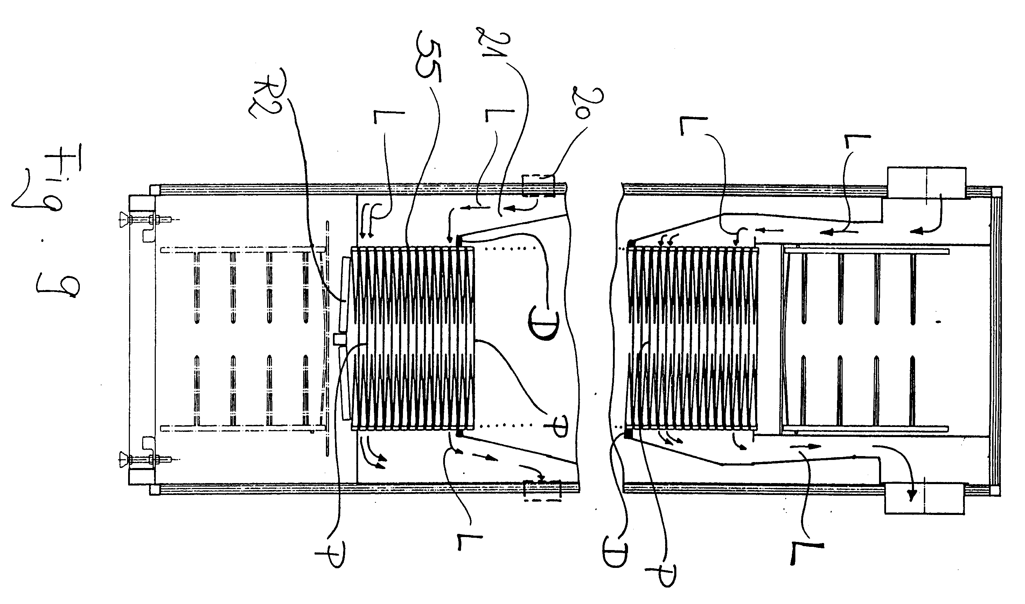

Das in Fig. 1 gezeigte Ausführungsbeispiel des erfindungsgemässen Durchlauftrockners 1 umfasst ein Trocknergehäuse 2 mit einer aufsteigenden Transportstrecke 30 und einer nach einem oberen Umlenkpunkt 31 wieder absteigenden Transportstrecke 32. Die Transportstrecke umfasst eine im wesentlichen vertikal verlaufende umlaufende Kette 4, an der Träger 5 für ein zu trocknendes Stückgut, beispielsweise eine Platte P, befestigt sind. Die Träger 5 stehen von der umlaufenden Kette 4 nach aussen ab. Ferner umfasst der Durchlauftrockner noch eine Zuführung 21 für Trockenluft, die aus zeichnerischen Gründen hier nicht dargestellt ist (siehe Fig. 9).

In einem groben Gesamtüberblick funktioniert das in Fig. 1 dargestellte Ausführungsbeispiel des Trockners folgendermassen: Eine zu trocknende Platte P wird dem Trockner zugeführt. Dies kann beispielsweise so geschehen, dass die Platte auf einer Rollenbahn R1 in Richtung des Pfeils E in den Trockner einlaufen. Ein von unterhalb dieser Rollenbahn R1 kommender Träger 5, der an der umlaufenden Kette 4 befestigt und mit der Kette 4 mitbewegt wird, hebt die zu trocknende Platte P von der Rollenbahn R1 ab und transportiert sie aufwärts. Um das Beladen eines Trägers zu erleichtern, kann der Antrieb der Kette 4 unterbrochen werden, die Platte P in Richtung des Pfeils E auf der Rollenbahn R1 in den Trockner einlaufen und anschliessend die Kette 4 wieder angetrieben werden, so dass der von unterhalb der Rollenbahn R1 kommende Träger 5 die Platte P dann von der Rollenbahn R1 abhebt. Wie die Träger 5 vorzugsweise ausgebildet sind, wird weiter unten noch im Detail erläutert. Ebenso wird auch noch erläutert, wie die Platte P während des Transports durch den Trockner auf dem Träger 5 aufliegt.

Der Träger 5 transportiert die Platte P aufwärts bis zum oberen Umlenkpunkt 31. Beim Passieren des Umlenkpunkts 31 klappt die transportierte Platte P nach vorne über und liegt während des nachfolgenden Abwärtsransports auf dem vorangehenden Träger auf. Erreicht der abwärts bewegte Träger 5 mit der jeweils aufliegenden Platte P das Niveau einer Rollenbahn R2, so wird der Träger 5 anschliessend zwar weiter abwärts bewegt, die Platte P allerdings bleibt auf der Rollenbahn R2 liegen, auf der sie dann in Richtung des Pfeils A aus dem Trockner abtransportiert wird. Dieser Abtransport der Platte P auf der Rollenbahn R2 erfolgt, bevor der nachfolgende von oben kommende Träger das Niveau der Rollenbahn R2 erreicht. Dies kann einerseits durch eine ausreichend hohe Transportgeschwindigkeit der Rollenbahn R2 bewirkt werden, so dass die umlaufende Kette 4 kontinuierlich weiterlaufen kann. Andererseits kann zur Erleichterung des Abtransports der Platte P auch ähnlich wie beim Einlaufen der Platte P der Antrieb der umlaufenden Kette 4 unterbrochen werden, sobald eine Platte P auf die Rollenbahn R2 gelangt ist. Während dieser Unterbrechung des Antriebs der Kette 4 kann dann die Platte P auf der Rollenbahn R2 in Richtung des Pfeils A abtransportiert werden. Insgesamt kann der Antrieb der Kette 4 generell auch intermittierend erfolgen, und zwar am besten derart, dass während einer Unterbrechung des Antriebs sowohl eingangsseitig eine zu trocknende Platte P in den Trockner einläuft und gleichzeitig ausgangsseitig auch eine bereits getrocknete Platte P aus dem Trockner ausläuft.

Während des Transports durch den Trockner strömt Trockenluft über die Platte P hinweg und zwar quer zu der Richtung, in der die Träger 5 von der Kette 4 abstehen. Insbesondere strömt die Trockenluft senkrecht zu dieser Richtung über die Platte P hinweg, also gemäss Fig. 1 entweder in die Zeichenebene hinein oder aus der Zeichenebene heraus. Dies ergibt, wie bereits weiter oben erwähnt, einen kurzen Luftweg und Gleichmässigkeit des Lufstroms und ist für die Trocknung der Platten besonders vorteilhaft.

Um die besondere Art und Weise der Lufstromführung besser verstehen zu können, wird im folgenden zunächst eine Ausgestaltung der Träger 5 beschrieben, die besonders vorteilhaft ist, da sie eine derartige Luftstromführung ermöglicht und zudem auch noch hinsichtlich einer hohen Packungsdichte besonders vorteilhaft ist. In Fig. 2 ist ein Ausführungsbeispiel eines solchen Trägers 5 im Zusammenbau erkennbar. Der Träger 5 umfasst jeweils zwei Seitenholme 50 und 51, die an ihrem Fussende, das in montiertem Zustand der Kette 4 zugewandt ist, durch einen Verbindungssteg 52 miteinander verbunden sind. An den Seitenholmen 50 und 51 sind Tragelemente 53 befestigt, die im wesentlichen V-förmig ausgebildet sind Die Tragelemente 53 sind so an den jeweiligen Seitenholmen 50 und 51 befestigt, dass ihre Spitzen 530 jeweils auf den anderen Seitenholm zuweisen. Von den Enden 531 und 532 der V-förmigen Tragelemente 53 ist eines an der Oberseite des jeweiligen Seitenholms 50 bzw. 51 und das andere an der Unterseite dieses Seitenholms befestigt.

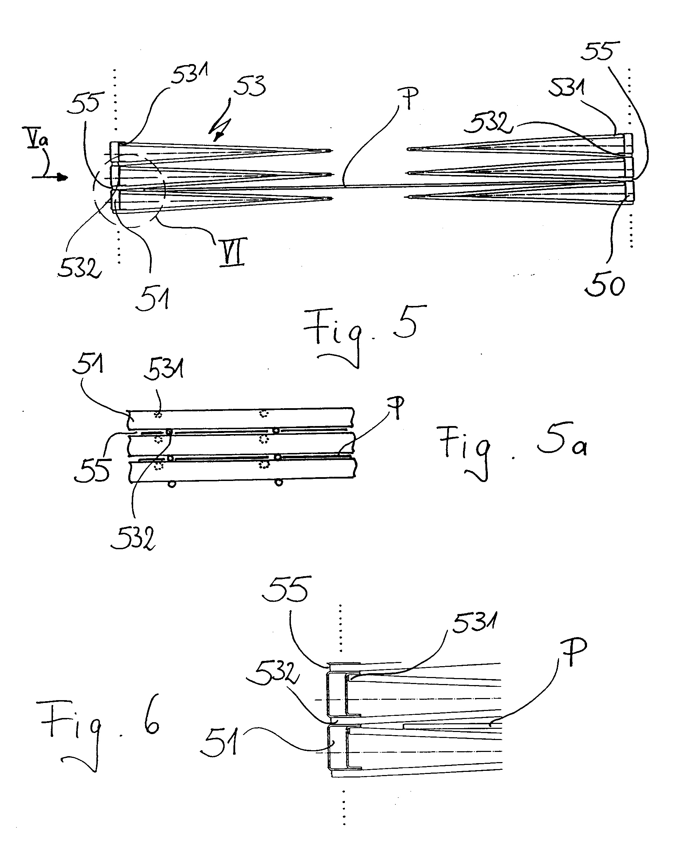

Die Art und Weise, wie diese Enden 531 und 532 der Tragelemente 53 an der Ober- bzw. an der Unterseite des jeweiligen Seitenholms 50 bzw. 51 befestigt sind, ist in Fig. 4 besonders gut erkennbar, welche eine Ansicht eines Trägers 5 gemäss der Linie IV-IV der Fig. 2 zeigt. Dort erkennt man, dass die Seitenholme 50 und 51 jeweils etwa ein U-Profil aufweisen, dessen Schenkel 501 und 502 bzw. 511 und 512 jeweils auf den anderen Seitenholm zuweisen. Beispielsweise ist dabei das eine Ende 531 des Tragelements 53 an der Innenwand des einen Schenkels 501 und das andere Ende 532 des Tragelements 53 an der Aussenwand des Schenkels 502 befestigt. Die Breite B eines Seitenholms zuzüglich der Dicke der Tragelemente 53 überschreitet dabei die Länge eines Glieds der Kette 4 nicht. Soll eine möglichst hohe Packungsdichte erreicht werden, so folgen die Träger 5 möglichst dicht aufeinander. Im Grenzfall entspricht die Summe aus der Breite B eines Seitenholms zuzüglich der Dicke eines Tragelements 53 gerade der Länge eines Kettenglieds. Dabei wirken die auf der Aussenseite eines Seitenholms befestigten Enden 532 eines Tragelements 53 als Abstandshalter zwischen aufeinanderfolgenden Seitenholmen, so dass ein Schlitz 55 zwischen den aufeinanderfolgenden Seitenholmen gebildet ist (Fig. 5). Durch diesen Schlitz wird die Trockenluft zugeführt, die die beschichteten Platten trocknet, die auf den Tragelementen 53 aufliegen.

In Fig. 3, die eine Ansicht gemäss der Linie III-III der Fig. 2 zeigt, ist gut zu erkennen, dass in der Nähe des Fussendes der Seitenholme 50 und 51 Stützstege vorgesehen sind, von denen in Fig. 3 nur ein Stützsteg 54 dargestellt ist. Die Stutzstege 54, die auch in Fig. 2 gut zu erkennen sind, erstrecken sich jeweils zwischen zwei aufeinanderfolgenden Seitenholmen zweier Träger und reichen von dem einen Seitenholm 50 bis hinüber zum anderen Seitenholm 51. Gegen diese Stützstege 54 stützt sich die transportierte zu trocknende Platte P insbesondere dann, wenn der Träger 5 in den Bereich des oberen Umlenkpunkts 31 der Transportstrecke gelangt.

Bisher sind nun die Träger 5 beschrieben worden, ohne dass dabei die Platten P, die ja auf den Tragelementen 53 der Träger 5 aufliegen, dargestellt worden sind. In Fig. 5, in der drei aufeinanderfolgende Träger während des Aufwärtstransports dargestellt sind, erkennt man nun, wie die Platten P (dargestellt ist aus zeichnerischen Gründen nur eine Platte P) auf diesen Tragelementen 53 der Träger 5 aufliegen. Man erkennt so auch deutlich, dass mit dieser Anordnung eine sehr hohe Packungsdichte erreicht werden kann. Wie dabei die Luft prinzipiell über die zu trocknende Platte geführt ist, erkennt man in Fig. 5a. Die "freien" Enden 532 wirken als Abstandshalter zwischen zwei aufeinanderfolgenden Seitenholmen, so dass die Schlitze 55 gebildet werden. Die Trockenluft strömt nun durch diese Schlitze 55 über die Platte P, die ebenfalls angedeutet ist, hinweg. In Fig. 5a strömt die Luft dabei in einer Richtung entweder in die Zeichenebene hinein oder aus der Zeichenebene heraus.

Das Detail VI der Fig. 5 ist in Fig. 6 noch einmal vergrössert herausgezeichnet. Es ist in dieser vergrösserten Darstellung gut erkennbar, dass die Platte P nur an ihren Seitenrändern auf den Tragelementen 53 aufliegt. Da Beschichtung der Platten P üblicherweise nicht ganz an ihre Seitenrändern heranreicht, liegt die Platte P nur in einem unbeschichteten Bereich auf den Tragelementen auf. Durch die Schlitze 55, die durch die jeweiligen Enden der Tragelemente bewirkt werden, wird Trockenluft zugeführt, die quer zu der Richtung, in der die Träger 5 von der Kette 4 abstehen (siehe hierzu Fig. 1), über die Platte P strömt und so die Platte trocknet.

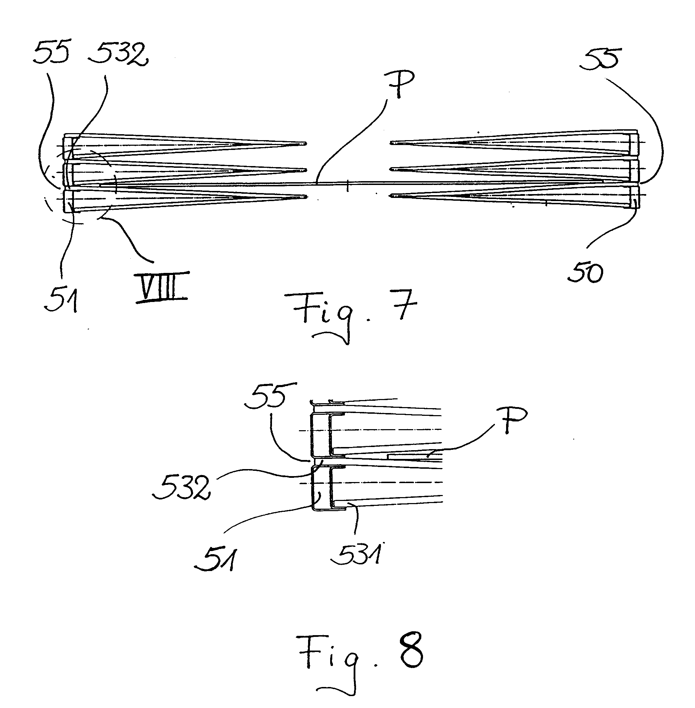

In Fig. 7 sind ähnlich wie in Fig. 5 drei aufeinanderfolgende Träger dargestellt, allerdings hier während des Abwärtstransports. Man erekennt dies daran, dass die Platte nun auf einem Tragelement 53 dort aufliegt, wo das Ende 532 aussen am Seitenholm 51 befestigt ist, im Unterschied zum Aufwärtstransport gemäss Fig. 5. Die Platte P klappt nämlich wie bereits erläutert beim Passieren des oberen Umlenkpunkts 31 (Fig. 1) auf den vorangehenden Träger über. Durch diese Art und Weise des Aufliegens der Platte P auf den Tragelementen 53 ist gewährleistet, dass der Trockenluftstrom stets über die beschichtete Seite der Platte strömt und die Trocknung sehr effektiv ist Fig. 8 zeigt zur Verdeutlichung des Aufliegens der Platte P auf den Tragelementen 53 das Detail VIII der Fig. 7 noch einmal vergrössert.

Nach der oben beschriebenen Erläuterung der Art und Weise des Plattentransports durch den Trockner wird im folgenden erläutert, wie der Luftstrom zur Trocknung über die Platten P geführt ist Generell ist hierzu bereits erwähnt, dass der Luftstrom quer zu der Richtung, in der die Träger 5 von der Kette 4 abstehen, über die Platte P geführt ist Dadurch wird ein kurzer Luftweg und ein gleichmässiger Lufststrom ermöglicht. Um eine besonders effektive Trocknung der Platte zu ermöglichen, sind in dem Trocknergehäuse Zonen vorgesehen, die auf unterschiedliche Temperaturen beheizt sind. In Fig. 1 sind diese Zonen Z1, Z2 und Z3 bereits angedeutet. Die Temperaturzonen Z1, Z2 und Z3 sind dabei thermisch voneinander getrennt In jeder Temperaturzone ist eine separate Zuführung für die Trockenluft vorgesehen. Nach dem Einlaufen der Platte in den Trockner 1 gelangt die Platte zunächst in die Zone Z1 im ersten Abschnitt der Transportstrecke, die als Vorwärmzone ausgebildet sein kann und in der die Temperatur in dem hier beschriebenen Ausführungsbeispiel im Bereich von etwa 30-70° C liegt und insbesondere etwa 50° C betragt. Anschliessend gelangt die Platte P in die Zone Z2, die als Heissluftzone ausgebildet sein kann, in der die Temperatur im Bereich von etwa 80-110° C liegt und insbesondere etwa 90° C beträgt. Abschliessend gelangt die Platte P noch in die Zone Z3, die als Abkühlzone ausgebildet sein kann und in der die Temperatur im Bereich von etwa 15-30° C liegt und insbesondere etwa 25° C beträgt. Nachdem die Platte auch diese Zone durchlaufen hat, gelangt sie wie bereits erläutert auf die Rollenbahn R2 und wird abtransportiert Selbstverständlich sind die genannten Temperaturbereiche in den einzelnen Zonen nur als beispielhaft zu betrachten, sie können je nach Plattenmaterial, verwendeter Beschichtungsmasse etc. auch in einem anderen Temperaturbereich liegen.

In Fig. 9, welche eine Ansicht gemäss der Linie IX-IX der Fig. 1 zeigt, ist erkennbar, dass die einzelnen Temperaturzonen voneinander thermisch getrennt sind und wie beispielsweise die Zufuhr der Trockenluft erfolgt. Aus Gründen der Übersichtlichkeit ist dabei der Trockner in der Mitte unterbrochen gezeichnet Die Zufuhr für die Trockenluft erfolgt über den Einlass 20, der in der unteren Hälfte des Trockners nur strichliert angedeutet ist, an den z.B. ein Luftzuführschlauch (nicht dargestelllt) angeschlossen sein kann. Die durch den Einlass 20 einströmende Luft strömt gemäss den Pfeilen L durch eine Zuführung 21 bis hin zu den Seitenholmen der Träger. Die Trennwände W1 und W2 (Fig. 1) sind an ihren den Seitenholmen zugewandten Enden mit lippenartigen Dichtungen D versehen, an denen die Seitenholme der Träger 5 vorbeigeführt sind Die gemäss den Pfeilen L zugeführte Luft strömt durch die Schlitze 55 zwischen aufeinanderfolgenden Trägern 5 hindurch über die Platte P hinweg (siehe auch Fig. 5a) und trocknet sie so. Auf der anderen Seite tritt die Luft durch den entsprechenden Schlitz 55 wieder aus und wird abgeführt Dabei kann die abgeführte Luft teilweise wieder zum Einlass geführt oder gänzlich erneuert werden. In gleicher Weise erfolgt in dem hier beschriebenen Ausführungsbeispiel die Luftzufuhr und ihre Abfuhr in den anderen Temperaturzonen.

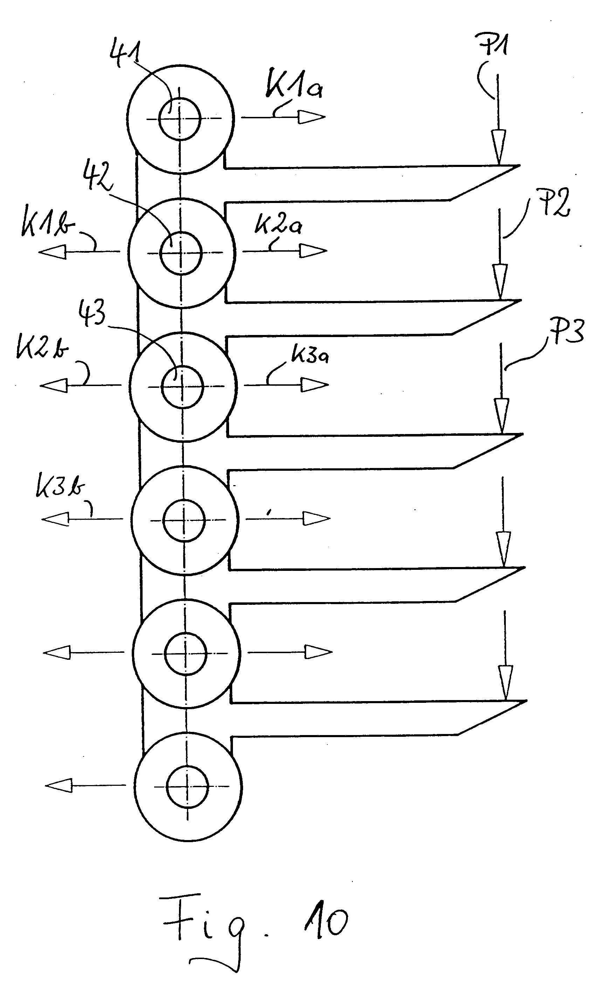

In einer Ausgestaltung des erfindungsgemässen Trockners ist die Befestigung der einzelnen Träger 5 an der Kette 4 noch auf eine besondere Art und Weise realisiert. Wie in der Einleitung bereits erwähnt, ist eine möglichst gleichmässige Belastung der Verbindungsstifte der einzelnen Glieder der Kette 4 besonders wünschenswert, damit die ganzen Kräfte bzw. Momente nicht von der Führung für die Kette bzw. von den Kettengliedern und deren Verbindungsstiften aufgenommen werden müssen. Darauf wurde prinzipiell schon in der EP-A-0 070 805 hingewiesen. Prinzipiell soll dies noch einmal anhand der Fig. 10 verdeutlicht werden. Das Eigengewicht einer auf einem Träger aufliegenden Platte P drückt gemäss dem Pfeil P1 auf den Träger. Dadurch wirkt auf den Verbindungsstift 41 der Kette 4 eine Kraft in Richtung des Pfeils K1a Durch die gleiche Platte wirkt auf den Verbindungsstift 42 eine Kraft in Richtung des Pfeils K1b. Gleiche Betrachtungen gelten für Kräfte, die gemäss den Pfeilen P2, K2a, K2b, P3, K3a, K3b auf die Verbindungsstifte 42, 43 und 44 wirken. Wenn also die Träger möglichst gleichmässig belastet und an allen Kettenglieder auch ein Träger befestigt ist, so können sich Kräfte auf die Verbindungsstifte der Kette 4 im Idealfall gänzlich oder wenigstens teilweise kompensieren, wodurch das "Rackpaket" stabil und die Kette 4 und die Führung der Kette entlastet wird, so dass deren Lebensdauer erhöht werden kann.

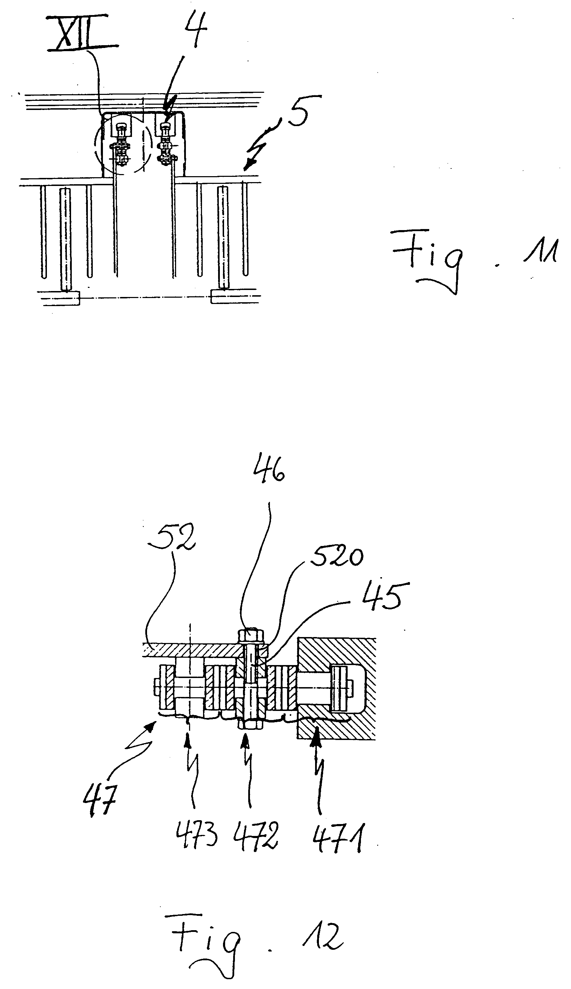

In Fig. 11 ist nun eine Ansicht gemäss der Linie XI-XI der Fig. 1 gezeigt, in der in einer Aufsicht die Kette 4 mit Trägern 5 gezeigt ist, wobei an jedem einzelnen Kettenglied ein Träger 5 befestigt ist. Die einzelnen Träger 5 sind bei dem beschriebenen Ausführungsbeispiel beispielsweise mit Hilfe von Gewindestiften 45 und Muttern 46 an der Kette 4 befestigt. Zu diesem Zweck sind in den Verbindungsstegen 52 Bohrungen 520 und 521 vorgesehen (Fig. 4), durch die hindurch die Gewindestifte 45 gesteckt und mit Hilfe der Muttern 46 an der Kette 4 fixiert werden. In Fig. 12, die das Detail XII der Fig. 11 vergrössert zeigt, ist diese Art der Befestigung erkennbar. Ausserdem ist dort auch erkennbar, dass die Transportstrecke zwei Triplex-Ketten 47 umfasst, von denen hier nur eine dargestellt ist. Eine solche Triplex Kette 47 umfasst jeweils drei miteinander verbundene parallel zueinander laufende Gliederbänder 471,472 und 473, wobei die einzelnen Gliederbänder durch Verbindungsstifte miteinander fest verbunden sind. Das jeweilige äusserste Gliederband 471 läuft in einer Führung um und dient nur zu Führungs- bzw. zu Antriebszwecken. An den anderen beiden Gliederbändern 472 und 473 sind die Träger 5 befestigt, und zwar immer abwechselnd an der einen Triplex-Kette am mittleren Gliederband 472 und an der anderen Kette am inneren Gliederband 473. In der Fig. 12 ist der Träger 5 an der dargestellten Triplex-Kette 47 am mittleren Gliederband befestigt. An der anderen (nicht dargestellten) Triplex-Kette ist er entsprechend am inneren Gliederband 473 befestigt. Um diese abwechselnde Befestigung an den Triplex-Ketten 47 zu ermöglichen, ist der dem in Fig. 4 gezeigten Träger nachfolgende Träger so ausgebildet, wie es dort strichliert angedeutet ist, d.h. der nachfolgende Träger ist am linken Ende etwas länger und weist dort die Bohrung 522 zur Befestigung des Trägers an der Triplex-Kette auf. Dafür ist er am rechten Ende etwas kürzer und dort mit der Bohrung 523 zur Befestigung des Trägers an der Triplex-Kette versehen. Diese abwechselnde Befestigung der Träger an den Triplex-Ketten 47 ist hinsichtlich einer hohen Packungsdichte vorteilhaft, da bei einer hohen Packungsdichte möglichst an allen Kettengliedern Träger befestigt sein müssen. Gelangt dann ein Kettenglied in den Bereich eines Umlenkpunkts, so muss der eine Träger und das Kettenglied mit umgelenkt werden, während das nachfolgende Kettenglied gerade noch nicht umgelenkt werden muss. Damit dies möglich ist und sich die Träger dabei nicht behindern, ist die vorgeschlagene Art und Weise der Befestigung der Träger an den Triplex-Ketten besonders vorteilhaft. Ausserdem ermöglicht diese Art der Befestigung an den Triplex-Ketten eine günsige Verteilung der Kräfte, die auf die Kette wirken, wie es bereits weiter oben erläutert ist. Um dies zu erreichen kann selbstverständlich statt der Triplex-Kette auch eine Spezialkette eingesetzt werden, die erlaubt, zwischen jedem Bolzenpaar der Spezialkette einen Träger zu befestigen.

Der beschriebene Durchlauftrockner eignet sich besonders für die Trocknung von einseitig oder beidseitig beschichteten Leiterplatten, z.B. mit einem Lötstopplack. Gleichzeitig kann in diesem Trockner die Platte abgelüftet werden, da die Verweilzeit im Trockner relativ gross ist. Dadurch kann eine separate Ablüftstation eingespart werden. Wesentlich von Vorteil ist der vergleichsweise kurze Weg der Trockenluft über die einzelnen zu trocknenden Platten hinweg. Zusätzlich ist der Lufstrom sehr gleichmässig, was eine gleichmässige und gute Trocknung der einzelnen Platten bewirkt Ein weiterer Vorteil ist die hohe erreichbare Packungsdichte an zu trocknenden Platten. Dies ist inbesondere durch die vorteilhafte Ausbildung der Träger einerseits und durch deren Befestigung und Transport mit Hilfe der Triplex-Ketten möglich. Ein weiterer Vorteil ergibt sich aus der Aufteilung in meherere Temperaturzonen, so dass die Platte langsam erwärmt und auch wieder gekühlt werden kann. Dies ist insbesondere hinsichtlich einer schonenden Behandlung des Plattenmaterials vorteilhaft Es ist aber auch hinsichtlich eines geringeren Energieverbrauchs gegenüber bekannten Trocknern vorteilhaft, deren Energieverbrauch durch das Heizen der Trockenluft erheblich über dem Verbrauch des erfindungsgemässen Trockners liegt.

## Patentansprüche

1. Durchlauftrockner für flächenförmiges Stückmaterial (P), insbesondere für flüssigbeschichtete Leiterplatten, und dergleichen, mit einem beheizbaren Trocknergehäuse (2) und einer in diesem Gehäuse aufsteigenden (30) und nach einem oberen Umlenkpunkt (31) wieder absteigenden (32) Transportstrecke, die eine im wesentlichen vertikal verlaufende umlaufende Kette (4) umfasst, an der Träger (5) für das zu transportierende Stückmaterial (P) befestigt sind, welche von der umlaufenden Kette (4) nach aussen abstehen, und mit einer Zuführung (21) für Trockenluft (L) für das zu trocknende Stückmaterial (P), wobei diese Zuführung (21) so angeordnet ist, dass ein von ihr zugeführter Luftstrom (L) quer zu der Richtung, in der die Träger (5) von den Kettengliedern abstehen, über das Stückmaterial (P) strömt, dadurch gekennzeichnet, dass die an den Gliedern der Kette (4) befestigten Träger (5) jeweils zwei Seitenholme (50,51) umfassen, die an ihrem der Kette zugewandten Fussende durch einen Verbindungssteg (52) verbunden sind, dass an den Seitenholmen (50,51) im wesentlichen V-förmige Tragelemente (53) befestigt sind, deren Spitzen jeweils etwa auf den anderen Seitenholm zuweisen, und dass von den beiden Enden (531,532) dieser V-förmigen Tragelemente (53) das eine an der Oberseite und das andere an der Unterseite des zugehörigen Seitenholmes (50,51) befestigt ist.

2. Durchlauftrockner nach Anspruch 1, dadurch gekennzeichnet, dass die Zuführung (21) für die Trockenluft seitlich neben der Transportstrecke (30,31,32) für das Stückmaterial (P) angeordnet und in das Trocknergehäuse (2) integriert ist.

3. Durchlauftrockner nach Anspruch 1 oder 2, dadurch gekennzeichnet, dass an jedem Glied der Kette (4) ein Träger (5) befestigt ist, dass die beiden Seitenholme (50,51) eines Trägers jeweils etwa ein U-Profil aufweisen, dessen Schenkel (501,502,511,512) jeweils auf den anderen Holm zuweisen, und dass das eine Ende (532) eines Tragelements an der Aussenwand des einen U-Schenkels (502,512) und das andere Ende (531) an der Innenwand des anderen U-Schenkels (501,511) des jeweiligen Seitenholms (50,51) befestigt sind und die Breite (B) der Seitenholme (50,51) zuzüglich der Dicke der Tragelemente (53) die Länge eines Glieds der Kette (4) nicht überschreitet.

4. Durchlauftrockner nach einem der Ansprüche 1 bis 3, dadurch gekennzeichnet, dass die Transportstrecke zwei Triplex-Ketten (47) umfasst, die jeweils drei miteinander verbundene parallel zueinander umlaufende Gliederbänder (471,472,473) umfassen, wobei das jeweilige äussere Gliederband (471) in einer Führung umläuft und an den beiden anderen Gliederbändern (472,473) die Träger (5) abwechselnd an der einen Triplex-Kette am mittleren Gliederband (472) und gleichzeitig an der anderen Triplex-Kette am inneren Gliederband (473) befestigt sind.

5. Durchlauftrockner nach einem der Ansprüche 1 bis 4, dadurch gekennzeichnet, dass in der Nahe des Fussendes der Seitenholme Stützstege (54) für das Stückmaterial (P) vorgesehen sind, die sich jeweils zwischen zwei hintereinander folgenden Seitenholmen (50) zweier Träger (5) zu den zugehörigen gegenüberliegenden Seitenholmen (51) hin erstrecken.

6. Durchlauftrockner nach einem der Ansprüche 1 bis 5, dadurch gekennzeichnet, dass in dem Trocknergehäuse (2) mehrere Zonen (Z1,Z2,Z3) vorgesehen sind, die auf unterschiedliche Temperaturen beheizt und voneinander thermisch getrennt sind, und dass in jeder Temperaturzone eine separate Zuführung (21) für Trockenluft (L) vorgesehen ist.

7. Durchlauftrockner nach Anspruch 6, dadurch gekennzeichnet, dass die Temperaturzonen eine erste Vorwärmzone (Z1) im ersten Abschnitt der Transportstrecke umfassen, in der die Temperatur im Bereich von etwa 30-70° C liegt, dass die Temperatur in einer nachfolgenden Heissluftzone (Z2) im Bereich von etwa 80-110° C und in einer abschliessenden Abkühlzone (Z3) im Bereich von etwa 15-30° C liegt.

8. Durchlauftrockner nach einem der Ansprüche 6 oder 7, dadurch gekennzeichnet, dass die Temperaturzonen (Z1,Z2,Z3) durch Trennwände (W1,W2) voneinander getrennt sind, die sich von dem seitlichen Gehäuseaufbau weg bis zu den Seitenholmen hin erstrecken und die mit lippenartige Dichtungen (D) versehen sind, an denen die Seitenholme (50,51) der Träger (5) vorbeigeführt sind.

## Claims

1. A continuous drier for flat piece material (P), especially for liquid-coated printed circuit boards, and the like, comprising a heatable drier housing (2) and a transport path that ascends (30) and, after passing an upper turning point (31), descends (32) again in that housing, which transport path comprises a circulating chain (4) that extends substantially vertically and to which are secured carriers (5) for the piece material (P) to be transported, which carriers project outward from the circulating chain (4), and comprising a supply duct (21) for drying air (L) for the piece material (P) to be dried, the supply duct (21) being so arranged that an airstream (L) supplied by it flows over the piece material (P) transversely to the direction in which the carriers (5) project from the chain links, wherein each of the carriers (5) secured to the links of the chain (4) comprises two lateral bars (50, 51) which, at their base ends towards the chain, are connected by a connecting strip (52), wherein there are secured to the lateral bars (50, 51) substantially V-shaped carrying members (53) of which the vertices point approximately in the direction of the other lateral bar, and wherein, of the two ends (531, 532) of those V-shaped carrying members (53), one is secured to the upper side and the other is secured to the lower side of the associated lateral bar (50, 51).

2. A continuous drier according to claim 1, wherein the supply duct (21) for the drying air is arranged laterally adjacent to the transport path (30, 31, 32) for the piece material (P) and is integrated in the drier housing (2).

3. A continuous drier according to claim 1 or claim 2, wherein a carrier (5) is secured to each link of the chain (4), each of the two lateral bars (50, 51) of a carrier has an approximately U-shaped profile of which the arms (501, 502, 511, 512) point towards the other bar, and one end (532) of a carrying member is secured to the outer wall of one arm (502, 512) of the U and the other end (531) is secured to the inner wall of the other arm (501, 511) of the U of the lateral bar (50, 51) concerned, and the width (B) of the lateral bars (50, 51) together with the thickness of the carrying members (53) does not exceed the length of a link of the chain (4).

4. A continuous drier according to any one of claims 1 to 3, wherein the transport path comprises two triplex chains (47) each of which comprises three interconnected link conveyors (471, 472, 473) circulating parallel to one another, the outermost link conveyor (471) circulating in a guideway and, on the two other link conveyors (472, 473), the carriers (5) being secured in an alternating manner to the middle link conveyor (472) of the one triplex chain and, at the same time, to the innermost link conveyor (473) of the other triplex chain.

5. A continuous drier according to any one of claims 1 to 4, wherein support strips (54) for the piece material (P) are provided near the base ends of the lateral bars, each of which support strips (54) extends between two consecutive lateral bars (50) of two carriers (5) to the associated, opposite lateral bars (51).

6. A continuous drier according to any one of claims 1 to 5, wherein several zones (Z1, Z2, Z3) are provided in the drier housing (2) which are heated to different temperatures and are thermally separated from one another, and a separate supply duct (21) for drying air (L) is provided in each temperature zone.

7. A continuous drier according to claim 6, wherein the temperature zones comprise a first, preheating zone (Z1) in a first portion of the transport path, in which zone the temperature is in the range of approximately from 30 to 70°C, and the temperature in a subsequent, hot-air zone (Z2) is in the range of approximately from 80 to 110°C and, in a final, cooling zone (Z3), is in the range of approximately from 15 to 30°C.

8. A continuous drier according to either claim 6 or claim 7, wherein the temperature zones (Z1, Z2, Z3) are separated from one another by separating walls (W1, W2) that extend from the lateral body of the housing as far as the lateral bars and are provided with lip-like seals (D) past which the lateral bars (50, 51) of the carriers (5) are conveyed.

## Revendications

1. Sécheur traversé en continu pour des articles (P) de forme plate, en particulier pour des plaquettes de circuits imprimés revêtues d'un liquide et pour des articles analogues, cet appareil comportant un carter (2) chauffable et, dans ce carter, un trajet de transport ascendant (30) et descendant à nouveau (32) après un point de renvoi (31) supérieur, ce trajet comportant une chaîne (4) tournant sans fin dans une direction essentiellement verticale, chaîne sur laquelle sont fixés des supports (5) pour des articles (P) à transporter, ces supports faisant saillie vers l'extérieur de la chaîne (4) tournant sans fin et l'appareil comportant une amenée (21) d'alimentation en de l'air sec ou de séchage (L) pour traiter les articles (P) à sécher, cette amenée (21) d'alimentation étant agencée de façon qu'un courant d'air (L) qui lui est amené circule sur les articles (P) perpendiculairement ou transversalement à la direction dans laquelle les supports (5) font saillie des chaînons de la chaîne, sécheur caractérisé en ce que les supports (5) fixés sur les chaînons de la chaîne (4) comportent chacun deux montants latéraux (50, 51) qui sont reliés à leur extrémité de pied ou de base tournée vers la chaîne par une barrette (52) de liaison ; en ce que sont fixés sur les montants latéraux (50, 51) des éléments porteurs (53) ayant essentiellement une forme de V et dont les pointes sont chaque fois tournées approximativement vers l'autre montant latéral ; et en ce que, des deux extrémités (531, 532) de ces éléments porteurs (53) en forme de V, une extrémité est fixée sur le côté supérieur et l'autre sur le côté inférieur du montant latéral (50, 51) correspondant.

2. Sécheur traversé en continu selon la revendication 1, caractérisé en ce que l'amenée (21) d'alimentation en air sec ou de séchage est agencée latéralement près du trajet de transport (30, 31, 32) des articles (P) et est intégrée dans le carter (2) du sécheur.

3. Sécheur traversé en continu selon la revendication 1 ou 2 caractérisé en ce que sur chaque chaînon de la chaîne (4) est fixé un support (5) ; en ce que les deux montants latéraux (50, 51) d'un support présentent chacun un profil approximativement en U, dont les branches (501, 502, 511, 512) sont chaque fois tournées vers l'autre montant ; et en ce qu une extrémité (532) d'un élément porteur est fixée (à chaque fois)sur la paroi extérieure d'une branche (502, 512) du U et l'autre extrémité (531) est fixée sur la paroi intérieure de l'autre branche (501, 511) du U du montant latéral correspondant (50, 51) et en ce que la largeur (B) des montants latéraux (50, 51) dans le sens de l'épaisseur des éléments porteurs (53) n'excède pas la longueur d'un chaînon de la chaîne (4).

4. Sécheur traversé en continu selon l'une des revendications 1 à 3, caractérisé en ce que le trajet de transport comporte deux chaînes (47) en triple ou "triplex", qui comportent chacune trois bandes transporteuses (471, 472, 473) à maillons, reliées les unes aux autres et tournant sans fin parallélement l'une à l'autre, la bande transporteuse (471) à chaque fois extérieure se déplaçant dans une glissière de guidage et les supports (5) étant fixés sur les deux autres bandes transporteuses (472, 473) en étant alternativement fixés sur une bande transporteuse (472) médiane d'une chaîne "triplex" et en étant simultanément fixés sur une bande transporteuse (473) intérieure de l'autre chaîne "triplex".

5. Sécheur traversé en continu selon l'une des revendications 1 à 4, caractérisé en ce qu'au voisinage de l'extrémité de base ou de pied des montants latéraux, sont prévues des barrettes (54) pour l'appui des articles (P), barrettes qui s'étendent chaque fois entre deux montants latéraux (50) successifs de deux supports (5) et se dirigent vers les montants latéraux (51) opposés correspondants.

6. Sécheur traversé en continu selon l'une des revendications 1 à 5, caractérisé en ce que sont prévues dans le carter (2) de ce sécheur plusieurs zones (Z1, Z2, Z3) qui sont chauffées à des températures différentes et sont thermiquement séparées l'une de l'autre, et en ce que, dans chaque zone de température, on prévoit une amenée séparée (21) d'air de séchage (L).

7. Sécheur traversé en continu selon la revendication 6, caractérisé en ce que les zones de température comportent une première zone de préchauffage (Z1) dans un premier tronçon du trajet de transport, zone dans laquelle la température se situe dans l'intervalle d'environ 30 à 70 °C ; en ce que la température régnant dans une zone (Z2) suivante d'air chaud se situe entre environ 80 et 110 °C, cette température se situe dans une zone (Z3) finale de refroidissement dans un intervalle d'environ 15 à 30 °C.

8. Sécheur traversé en continu selon l'une des revendications 6 à 7, caractérisé en ce que les zones de température (Z1, Z2, Z3) sont séparées l'une de l'autre par des cloisons (W1, W2), qui s'étendent depuis la structure latérale du carter jusqu'aux montants latéraux et qui comportent des garnitures d'étanchéité (D) du genre à lèvres, sur lesquelles passent les montants latéraux (50, 51) des supports (5).
